Europäisches Patentamt

European Patent Office

Office européen des brevets

(11) Veröffentlichungsnummer: **0 445 421 A2**

## (12) EUROPÄISCHE PATENTANMELDUNG

(21) Anmeldenummer: 90125297.3

(22) Anmeldetag: 21.12.90

(51) Int. Cl.5: **H03K 19/003**

(30) Priorität: 07.03.90 DE 4007212

(43) Veröffentlichungstag der Anmeldung:
11.09.91 Patentblatt 91/37

(84) Benannte Vertragsstaaten:
DE FR GB IT NL

(71) Anmelder: **Siemens Aktiengesellschaft**
**Wittelsbacherplatz 2**
**W-8000 München 2(DE)**

(72) Erfinder: **Barré, Claude, Dipl.-Ing.**
**Implerstrasse 23**
**W-8000 München 70(DE)**

(54) **Integrierbare Transistorschaltung zur Abgabe logischer Pegel.**

(57) Integrierbare Transistorschaltungen zur Abgabe logischer Pegel bestehen im allgemeinen aus der eigentlichen Schaltstufe (S) und einem zur Fan-Out-Erhöhung dienenden Schaltstufenausgangsstromverstärker (V). Die absoluten Ausgangspegel solcher Schaltungen hängen umso stärker von den Randbedingungen, beispielsweise Temperatur und Versorgungsspannungsschwankungen ab, je kleiner der in der Schaltstufe fließende Strom und je größer der den erzielbaren Spannungshub bestimmende Wert des Widerstandes (R1) sind. Die absoluten Ausgangsspannungspegel werden durch Zuordnung einer Pegelüberwachungsschaltung (P) in die Schaltstufe von den Randbedingungen weitgehend unabhängig. Am Steuereingang der Pegelüberwachungsschaltung (P) liegt eine Referenzspannung (VB2) an, die den Absolutwert eines der beiden logischen Ausgangsspannungspegel festlegt.

FIG 1

EP 0 445 421 A2

Die Erfindung betrifft eine integrierbare Transistorschaltung zur Abgabe logischer Pegel nach dem Oberbegriff des Patentanspruchs 1.

Schaltstufen nach dem Oberbegriff des Patentanspruchs 1 geben an ihrem Schaltstufenausgang einen einen bestimmten logischen Zustand repräsentierenden High- oder Low-Spannungspegel an der Schaltstufe nachgeschaltete Einheiten ab. Diese logischen Spannungspegel werden dadurch erzeugt, daß in der Reihenschaltung des Widerstandes mit dem Hauptstrompfad des Transistors (Kollektor-Emitterstrecke eines Bipolartransistors bzw. Drain-Sourcestrecke eines MOS-Transistors) entweder Strom fließt oder kein Strom fließt. Fließt kein Strom, so tritt am Widerstand kein Spannungsabfall auf und am Schaltstufenausgang liegt die Versorgungsspannung, mit der der Widerstand unmittelbar verbunden ist. Fließt dagegen Strom, so ist der Spannungsabfall am Widerstand von dessen Widerstandswert und von der Stromstärke durch den Widerstand abhängig.

Die Absolutwerte der logischen Spannungspegel sind für jede bekannte Logikfamilie in bestimmten Grenzen festgelegt. Die zulässige absolute Toleranz der absoluten Logikspannungspegel ist vom Absolutwert des Spannungsunterschiedes zwischen zwei logischen Zuständen - nachfolgend als "Hub" bezeichnet - abhängig. Bei kleinem Hub werden also die absoluten Toleranzen kleiner und somit die Einflüsse schwankender Versorgungsspannungen, Schwankungen des Ausgangslaststromes und Einflüsse der Temperatur immer kritischer. Zudem ist man bestrebt, den Stromverbrauch in integrierbaren Transistorschaltungen gering zu halten. Um einen bestimmten Hub zu erzielen, versucht man diesen durch eine geringe Stromstärke im Widerstand zu realisieren. Ein grösserer Widerstand verschlechtert aber die Bedingungen zur Einhaltung der Ausgangsspannungspegel.

Die der Erfindung zugrundeliegende Aufgabe ist es, die Abhängigkeit der logischen Ausgangsspannungspegel integrierbarer Transistorschaltungen von äußeren Einflüssen auf ein Mindestmaß zu verringern.

Diese Aufgabe wird erfindungsgemäß durch die im Patentanspruch 1 angegebenen Merkmale gelöst.

Die Ausgangspegel der Schaltstufe sind durch Einfügen der Pegelüberwachungsschaltung in weiten Bereichen unabhängig von äußeren Einflüssen. Bestimmt wird der absolute Wert eines Ausgangspegels jeweils durch eine Referenzspannung. Sollen beide logische Pegel überwacht werden, so sind dafür auch zwei Referenzspannungen notwendig, soll aber nur ein Pegel überwacht werden, benötigt man auch nur eine Referenzspannung.

Die Stromstärke in der Schaltstufe kann auf ein Mindestmaß gesenkt und der Wert des Widerstandes kann zur Erreichung des erforderlichen Hubs entsprechend erhöht werden. Die dadurch erzielbare Leistungseinsparung in der Schaltstufe ist weit grösser als der zusätzliche Leistungsbedarf, der für die Pegelüberwachungsschaltung erforderlich ist.

Besondere Bedeutung erlangt die Erfindung in einer Schaltungsanordnung gemäß Patentanspruch 2. Abgesehen von der Pegelüberwachungsschaltung beschreibt dieser Anspruch eine integrierbare Transistorschaltung, die einer Schaltstufe in ECL-Technik (Emitter Coupled Logic) entspricht und in dieser Technik als Ausgangsschaltung eingesetzt wird. Die von einer Ausgangsschaltung abgegebenen Logiksignale gelangen über Leitungen, beispielsweise Leiterbahnen einer Leiterplatte, zu einer Eingangsschaltung. Um ein Übersprechen von einer Leiterbahn zur anderen auf ein Mindestmaß zu beschränken, verringert man die Flankensteilheit der von der Ausgangsschaltung abgegebenen Signale. Eine damit einhergehende Erhöhung der Laufzeit in der Ausgangsschaltung nimmt man in Kauf, da bei einer Erhöhung der Gesamtlaufzeit - von der Eingangsschaltung über die eigentliche Logik zur Ausgangsschaltung - von 5 bis 10% eine Reduzierung des Übersprechens von einer Leitung zu anderen Leitungen auf den halben Wert bewirkt wird. In bekannten Ausgangsschaltungen wird die Verringerung der Flankensteilheit dadurch erreicht, daß vom Schaltstufenausgang zu einer Versorgungsspannung eine Kapazität, beispielsweise in Form einer erhöhten Eingangskapazität des als Schaltstufenausgangsstromverstärker dienenden npn-Bipolartransistors, eingeschaltet wird. Der Widerstand der Schaltstufe und die am Schaltstufenausgang eingeschaltete Kapazität wirken als Verzögerungsglied mit der Zeitkonstante = RxC. Ein großer Wert der Zeitkonstante läßt sich also folglich auch durch eine Erhöhung des Widerstandswertes erreichen. Die Erhöhung des Widerstandswertes kann aber erst durch das Zuordnen der erfindungsgemäßen Pegelüberwachungsschaltung zur Schaltstufe sinnvoll genutzt werden und damit dem Verfahren der Flankensteilheitsverringerung ein Leistungsverringerungseffekt hinzugefügt werden.

Vorteilhafte Ausgestaltungen und Weiterbildungen der erfindungsgemäßen Pegelüberwachungsschaltung sind in den Ansprüchen 3 bis 9 und im Anspruch 11 angegeben.

Eine Pegelüberwachungsschaltung aus einem sechsten npn-Bipolartransistor, dessen Kollektoranschluß mit der ersten Versorgungsspannung verbunden ist, und dessen Emitteranschluß mit dem Schaltstufenausgang verbunden ist, und dessen Basisanschluß als Steuereingang dient, ist auch in einer Schaltstufe gemäß Patentanspruch 10 in vorteilhafter Weise anwendbar. Diese Schaltstufenvariante ermöglicht es, an ihrem Eingang anliegende Spannungspegel - beispielsweise in der CMOS-Technik übliche - zum Schaltungsausgang hin in ECL-übliche Spannungspegel umzuwandeln. Aber erst durch den Einsatz der erfindungsgemäßen Pegelüberwachungsschaltung ist eine sinnvolle Anwendung dieser Schaltungsvariante möglich.

Mehrere Ausführungsbeispiele der Erfindung werden im folgenden anhand der Zeichnungen näher erläutert. Dabei zeigen

FIG 1 eine ECL-Ausgangsschaltung mit Überwachung des High-Pegels,

FIG 2 eine Schaltung nach FIG 1, jedoch ohne Transistor zwischen Überwachungsanschluß und Schaltstufenausgang,

FIG 3 eine Schaltung nach FIG 1, wobei die Pegelüberwachungsschaltung mit nur einer Versorgungsspannung verbunden ist und der MOS-Transistor durch einen pnp-Bipolartransistor ersetzt ist,

FIG 4 eine Schaltung nach FIG 3, bei der die Eigenschaften des MOS-Transistors durch einen npn-Transistor verstärkt werden,

FIG 5 eine Logikwandlerschaltung mit Low-Pegel-Überwachung,

FIG 6 eine ECL-Ausgangsschaltung mit Low-Pegel-Überwachung.

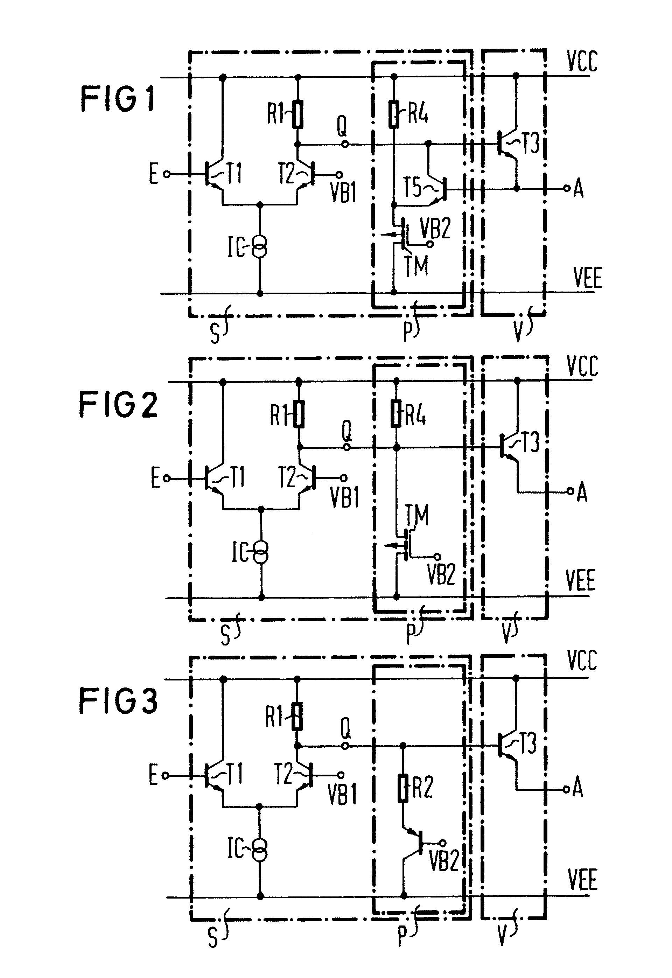

In der FIG 1 ist ein Schaltbild einer ECL-Ausgangsschaltung dargestellt, die aus einer Schaltstufe S mit darin enthaltener Pegelüberwachungsschaltung P und einem der Schaltstufe S nachgeschalteten Schaltstufenausgangsstromverstärker V besteht. Ein npn-Bipolartransistor T1 bildet mit einem zweiten npn-Bipolartransistor T2 einen Differenzschalter. Der Basisanschluß des ersten npn-Bipolartransistors T1 bildet einen Schaltstufeneingang E, während sein Kollektoranschluß mit einer ersten Versorgungsspannung VCC verbunden ist. Ein ebenfalls mit dieser ersten Versorgungsspannung VCC verbundener Widerstand R1 ist mit seinem zweiten Anschluß mit dem Kollektoranschluß des zweiten npn-Bipolartransistors T2 verbunden. Diese Verbindungsstelle wird als Schaltstufenausgang Q genutzt. Die Emitteranschlüsse der beiden npn-Bipolartransistoren T1, T2 sind über eine Konstantstromquelle IC mit einer zweiten Versorgungsspannung VEE verbunden. Die Schaltschwelle des Differenzschalters wird durch eine Referenzspannung VB1, die am Basisanschluß des zweiten npn-Bipolartransistors T2 anliegt, festgelegt. Der Schaltstufenausgang Q wirkt direkt auf den Basisanschluß eines dritten npn-Bipolartransistors T3, der als Schaltstufenausgangsstromverstärker V eingesetzt ist. Der Kollektoranschluß dieses dritten npn-Bipolartransistors T3 ist mit der ersten Versorgungsspannung VCC verbunden. Sein Emitteranschluß dient als Ausgang A der Gesamtschaltung.

Da die bisher geschilderten Schaltungselemente und ihre gegenseitigen Verbindungen für sämtliche Figuren, mit Ausnahme der FIG 5 zutreffen, werden im folgenden nur noch die sich voneinander unterscheidenden Pegelüberwachungsschaltungen P, die in den einzelnen Figuren dargestellt sind, erläutert.

Die in FIG 1 dargestellte Pegelüberwachungsschaltung P weist einen p-MOS-Transistor TM auf, dessen Drainanschluß mit der zweiten Versorgungsspannung VEE verbunden ist und an dessen Gateanschluß eine zweite Referenzspannung VB2 anliegt, die den Ausgangs-High-Pegel festlegt. Der Sourceanschluß des p-MOS-Transistors TM ist mit dem Emitteranschluß eines fünften npn-Bipolartransistors T5 und mit einem vierten Widerstand R4 verbunden, dessen anderer Anschluß mit der ersten Versorgungsspannung VCC verbunden ist. Der Basisanschluß des fünften npn-Bipolartransistors T5 ist mit dem Emitteranschluß des dritten npn-Bipolartransistors T3 verbunden, um die Spannung am Ausgang A der Gesamtschaltung zu überwachen, während der Kollektoranschluß des fünften npn-Bipolartransistors T5 mit dem Schaltstufenausgang Q verbunden ist. Ein Abfallen der Spannung am Ausgang A der Gesamtschaltung gegenüber der zweiten Referenzspannung VB2 bewirkt einen erhöhten Spannungsabfall in der Kollektor-Emitter-Strecke des fünften npn-Bipolartransistors T5 und somit eine Erhöhung der Spannung am Schaltstufenausgang Q, die über den dritten npn-Bipolartransistor T3 zum Ausgang A der Gesamtschaltung weitergegeben wird. Diese Schaltung wirkt also wie ein Regelkreis, dessen Sollgröße - der Spannungspegel am Schaltstufenausgang Q - durch die zweite Referenzspannung VB2 bestimmt wird. Durch den vierten Widerstand R4 wird der Arbeitspunkt der Pegelüberwachungsschaltung P so festgelegt, daß der Regelbereich möglichst groß wird.

Die in FIG 2 dargestellte Pegelüberwachungsschaltung P weist ebenfalls den vierten Widerstand R4 und den p-MOS-Transistor TM mit daran angeschlossener zweiter Referenzspannung VB2 auf. Im Gegensatz zu FIG 1 ist aber der fünfte npn-Bipolartransistor T5 weggelassen. Die Verbindungsstelle vom Sourceanschluß des p-MOS-Transistors TM zum vierten Widerstand R4, die auch als Überwachungsanschluß bezeichnet werden kann, ist jetzt direkt mit dem Schaltstufenausgang Q verbunden.

Die Pegelüberwachungsschaltung P in FIG 3 besteht aus einem pnp-Bipolartransistor TM1 und einem zweiten Widerstand R2. Der zweite Widerstand R2 ist direkt mit dem Schaltstufenausgang Q verbunden. An seinem zweiten Ende ist der Emitteranschluß des pnp-Bipolartransistors TM1 angeschlossen. Die zweite Referenzspannung VB2 steuert die Basis des pnp-Bipolartransistors TM1, dessen Kollektoranschluß mit der zweiten Versorgungsspannung VEE verbunden ist.

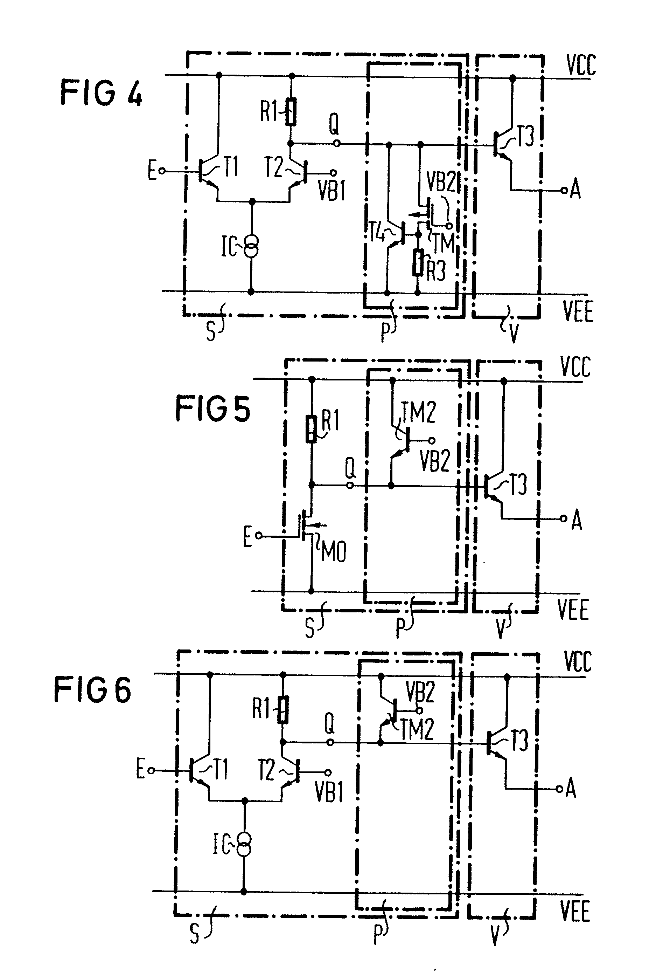

Die Pegelüberwachungsschaltung P in FIG 4 besteht aus dem p-MOS Transistor TM, einem dritten Widerstand R3 und einem vierten npn-Bipolartransistor T4. Der Emitteranschluß des npn-Bipolartransistors T4 und ein Anschluß des dritten Widerstandes R3 sind mit der zweiten Versorgungsspannung VEE verbunden. Der Drainanschluß des p-MOS-Transistors TM, der Basisanschluß des vierten npn-Bipolartransistors T4 und der zweite Anschluß des dritten Widerstandes R3 sind miteinander verbunden. Am Gateanschluß des p-MOS-Transistors TM liegt die zweite Referenzspannung VB2 an. Der Kollektoranschluß des npn-Bipolartransistors T4 und der Sourceanschluß des p-MOS-Transistors TM sind zu einem Überwachungsanschluß zusammengefaßt und mit dem Schaltstufenausgang Q verbunden. Diese Variante hat gegenüber einem einzelnen p-MOS-Transistor zwischen Schaltstufenausgang Q und zweiter Versorgungsspannung VEE den Vorteil, daß die durch den geometrischen Aufbau des p-MOS-Transistors bedingte relativ große parasitäre Kapazität nur bei High-Spannungspotential am Schaltungsausgang Q wirksam ist. Ein p-MOS-Transistor, dessen Eigenschaften verstärkt werden, kann auf kleinerem Raum als ein einzelner p-MOS-Transistor realisiert werden, so daß seine parasitäre Kapazität - wenn sie nicht von einem nachgeschalteten Transistor verstärkt wird - einen vergleichsweise kleinen Wert aufweist. Der vierte npn-Bipolartransistor T4 dient zur Verstärkung der Eigenschaften des p-MOS-Transistors TM. Liegen die zu einer Verstärkung notwendigen Spannungsverhältnisse nicht vor - wie beispielsweise bei Low-Pegel am Schaltungsausgang Q - dann werden auch die Eigenschaften des p-MOS-Transistors TM nicht verstärkt. Dies führt dazu, daß die möglicherweise störende Kapazität der Pegelüberwachungsschaltung T bei einem Wechsel von "Low" nach "High" am Schaltstufenausgang Q nicht wirksam ist.

Die Pegelüberwachungsschaltung P in FIG 6 überwacht den Low-Spannungspegel am Schaltungsausgang Q. Sie besteht aus einem sechsten npn-Bipolartransistor TM2, an dessen Basisanschluß, der als Steuereingang dient, die zweite Referenzspannung VB2 anliegt und dessen Kollektoranschluß mit der ersten Versorgungsspannung VCC verbunden ist. Der Emitteranschluß des sechsten npn-Bipolartransistors TM2 ist mit dem Schaltstufenausgang Q verbunden. Bei dieser Regelung des Low-Spannungspegels am Schaltstufenausgang Q ist eine geringere Genauigkeit der Stromquelle IC als ohne Low-Spannungspegelüberwachung notwendig.

In FIG 5 ist eine Schaltung zur Wandlung digitaler CMOS-Eingangsspannungspegel in digitale ECL-Ausgangsspannungspegel dargestellt. Diese Schaltung besteht aus einer Schaltstufe, einem Schaltstufenausgangsstromverstärker V und einer der Schaltstufe zugeordneten Pegelüberwachungsschaltung P. Die Schaltstufe S besteht aus einer Reihenschaltung, die aus dem ersten Widerstand R1 und einem n-MOS-Transistor MO gebildet ist. Ein Anschluß des Widerstandes R1 ist mit der ersten Versorgungsspannung VCC verbunden, während sein anderer Anschluß mit dem Sourceanschluß des n-MOS-Transistors verbunden ist und als Schaltstufenausgang Q dient. Der n-MOS-Transistor MO ist mit seinem Drainanschluß mit der zweiten Versorgungsspannung VEE verbunden und wird an seinem Gateanschluß, der als Schaltstufeneingang E dient, von digitalen Eingangssignalen mit in CMOS-Technik üblichen Spannungspegeln gesteuert. Der Ausgangsstrom wird durch den dritten npn-Bipolartransistor T3 verstärkt. Der Kollektoranschluß des dritten npn-Bipolartransistors T3 ist mit der ersten Versorgungsspannung VCC, sein Basisanschluß mit dem Schaltstufenausgang Q verbunden und der Emitteranschluß des dritten npn-Bipolartransistor T3 dient als Ausgang A der Gesamtschaltung. Der ECL-Low-Spannungspegel am Schaltstufenausgang Q wird vom sechsten npn-Bipolartransistor TM2 überwacht. Der Kollektoranschluß des sechsten npn-Bipolartransistors T2 ist mit der ersten Versorgungsspannung VCC und sein Emitteranschluß mit dem Schaltstufenausgang Q verbunden. Der Basisanschluß des sechsten npn-Bipolartransistors TM2 dient als Steuereingang, an dem die zweite Referenzspannung VB2 zur Bestimmung des Ausgangs-Low-Pegels anliegt.

**Patentansprüche**

1.  Integrierbare Transistorschaltung zur Abgabe logischer Pegel, bestehend aus einer Schaltstufe (S) und einem Schaltstufenausgangsstromverstärker (V), wobei die Schaltstufe (S) mindestens aus einer Reihenschaltung mindestens eines Widerstandes (R1) und dem Hauptstrompfad mindestens eines Transistors (T2) besteht und der Koppelpunkt des Widerstandes (R1), dessen eines Ende mit einer Versorgungsspannung (VCC) verbunden ist, mit dem als Schaltglied dienenden Transistor (T2) als Schaltstufenausgang (Q) dient, während der Steuereingang des Transistors (T2) als Schaltstufeneingang (E) dient und das zweite Ende der Reihenschaltung mit einer zweiten Versorgungsspannung (VEE) verbunden ist, **dadurch gekennzeichnet,** daß der Schaltstufe (S) eine Pegelüberwachungsschaltung (P) zugeordnet ist, daß die Pegelüberwachungsschaltung (P) mindestens einen Steuereingang aufweist, an dem eine den Schaltstufenausgangspegel bestimmende Referenzspannung (VB2) anliegt, daß die Pegelüberwachungsschaltung (P) zur Beeinflussung der logischen Pegel am Schaltstufenausgang (Q) mit dem Schaltstufenausgang (Q) verbunden ist und daß die Pegelüberwachungsschaltung (P) mindestens mit einer der beiden Versorgungsspannungen (VCC,VEE) verbunden ist.

2. Integrierbare Schaltung nach Anspruch 1, **dadurch gekennzeichnet,** daß die Schaltstufe (S) aus zwei an ihren Emitteranschlüssen zu einem Differenzschalter zusammengeschalteten npn-Bipolartransistoren (T1, T2) besteht, daß der Basisanschluß einer dieser npn-Bipolartransistoren (T1) als Schaltstufeneingang (E) dient, daß der Kollektoranschluß dieses Transistors (T1) direkt und der Kollektoranschluß des zweiten npn-Bipolartransistors (T2) indirekt über einen Widerstand (R1) mit der ersten Versorgungsspannung (VCC) verbunden ist, daß die Emitteranschlüsse der npn-Bipolartransistoren (T1, T2) an eine Stromquelle (IC) angeschlossen sind, die von der zweiten Versorgungsspannung (VEE) gespeist wird und daß der Schaltstufenausgangsstromverstärker (V) durch einen dritten npn-Bipolartransistor (T3) in Emitterfolgerschaltung realisiert ist, dessen Kollektoranschluß mit der ersten Versorgungsspannung (VCC) verbunden ist und dessen Basisanschluß mit dem als Schaltstufenausgang (Q) dienenden Kollektoranschluß des zweiten npn-Bipolartransistors (T2) verbunden ist.

3. Integrierbare Schaltung nach Anspruch 1 oder 2,
**dadurch gekennzeichnet,** daß die Pegelüberwachungsschaltung (P) aus einem p-MOS-Transistor (TM) besteht, daß der Drainanschluß des p-MOS-Transistors (TM) mit der zweiten Versorgungsspannung (VEE) verbunden ist, daß der Sourceanschluß des p-MOS-Transistors (TM) mit dem Schaltstufenausgang (Q) verbunden ist und daß der Gateanschluß des p-MOS-Transistors (TM) als Steuereingang dient.

4. Integrierbare Schaltung nach Anspruch 1 oder 2,
**dadurch gekennzeichnet,** daß die Pegelüberwachungsschaltung (P) aus der Serienschaltung eines pnp-Bipolartransistors (TM1) und eines zweiten Widerstandes (R2) besteht, daß der eine Anschluß des Widerstandes (R2) mit dem Emitteranschluß des pnp-Bipolartransistors (TM1) verbunden ist, daß der andere Anschluß des Widerstandes mit dem Schaltstufenausgang (Q) verbunden ist, daß der Kollektoranschluß des pnp-Bipolartransistors (TM1) mit der zweiten Versorgungsspannung

(VEE) verbunden ist und daß der Basisanschluß des pnp-Bipolartransistors (TM1) als Steuereingang dient.

5. Integrierbare Schaltung nach Anspruch 3, **dadurch gekennzeichnet,** daß zwischen dem Drain-Anschluß des p-MOS-Transistors (TM) und der zweiten Versorgungsspannung (VEE) ein dritter Wiederstand (R3) geschaltet ist, daß der Kollektoranschluß eines vierten npn-Bipolartransistors (T4), dessen Basisanschluß mit dem Drainanschluß des p-MOS-Transistors (TM) verbunden ist, mit dem Schaltstufenausgang (Q) verbunden ist und daß der Emitteranschluß des vierten npn-Bipolartransistors (T4) mit der zweiten Versorgungsspannung (VEE) verbunden ist.

6. Integrierbare Schaltung nach einem der Ansprüche 3, 4 oder 5, **dadurch gekennzeichnet,** daß die Anschlüsse der Pegelüberwachungsschaltung (P), die mit dem Schaltstufenausgang (Q) verbunden sind, zu einem Überwachungsanschluß zusammengefaßt werden, daß ein vierter Widerstand (R4) an einem Ende mit dem Überwachungsanschluß verbunden ist und daß der vierte Widerstand (R4) am anderen Ende mit der ersten Versorgungsspannung (VCC) verbunden ist.

7. Integrierbare Schaltung nach Anspruch 6, **dadurch gekennzeichnet,** daß zwischen dem Überwachungsanschluß und dem Schaltstufenausgang (Q) die Kollektor-Emitter-Strecke eines fünften npn-Bipolartransistors (T5) so eingefügt ist, daß dessen Emitteranschluß mit dem Überwachungsanschluß verbunden ist.

8. Integrierbare Schaltung nach Anspruch 7, **dadurch gekennzeichnet,** daß der Basisanschluß des fünften npn-Bipolartransistors (T5) mit dem Emitteranschluß des dritten npn-Bipolartransistors (T3) verbunden ist.

9. Integrierbare Schaltung nach Anspruch 7, **dadurch gekennzeichnet,** daß der Basisanschluß des fünften npn-Bipolartransistors (T5) mit dem Schaltstufenausgang (Q) verbunden ist.

10. Integrierbare Schaltung nach Anspruch 1, **dadurch gekennzeichnet,** daß die Schaltstufe (S) aus der Reihenschaltung des ersten Widerstandes (R1) und der Drain-Source-Strecke eines MOS-Transistors (MO) besteht, daß dessen Gate-Anschluß als Schaltstufeneingang (E) dient, daß der Koppelpunkt der Elemente der Reihenschaltung als Schaltstufenausgang (Q) dient, daß der zweite Anschluß des ersten Widerstandes (R1) mit der ersten Versorgungsspannung (VCC) verbunden ist, daß der Drain-Anschluß des MOS-Transistors (MO) mit der zweiten Versorgungsspannung verbunden ist und daß der Schaltstufenausgangsstromverstärker (V) durch einen dritten npn-Bipolartransistor (T3) in Emitterfolgerschaltung realisiert ist, dessen Kollektoranschluß mit der ersten Versorgungsspannung (VCC) verbunden ist und dessen Basisanschluß mit dem Schaltstufenausgang (Q) verbunden ist.

11. Integrierbare Schaltung nach einem der Ansprüche 1, 2 oder 10,
**dadurch gekennzeichnet,** daß die Pegelüberwachungsschaltung aus einem sechsten npn-Bipolartransistor (TM2) besteht, daß der Kollektoranschluß des sechsten npn-Bipolartransistors (TM2) mit der ersten Versorgungsspannung (vcc) verbunden ist, daß der Emitteranschluß des sechsten npn-Bipolartransistors (TM2) mit dem Schaltstufenausgang (Q) verbunden ist und daß der Basisanschluß des sechsten npn-Bipolartransistors (TM2) als Steuereingang dient.

FIG 1

FIG 2

FIG 3

FIG 4

FIG 5

FIG 6